# EUROPÄISCHE PATENTSCHRIFT

(11) **EP 4 341 714 B1**
(45) Veröffentlichungstag und Bekanntmachung des Hinweises auf die Patenterteilung: **05.03.2025**
(21) Anmeldenummer: 22725359.8
(22) Anmeldetag: 17.05.2022
(51) Int. Cl.: G01R 31/42, G01R 31/52, B60L 3/00

(54) **ELEKTRISCHE SCHALTUNGSANORDNUNG UND VERFAHREN ZUR DETEKTION EINES KURZSCHLUSSES**
ELECTRICAL CIRCUIT ARRANGEMENT AND METHOD FOR DETECTING A SHORT CIRCUIT
AGENCEMENT DE CIRCUIT ÉLECTRIQUE ET PROCÉDÉ DE DÉTECTION D'UN COURT-CIRCUIT

(30) Priorität: 18.05.2021 DE 102021112808
(43) Veröffentlichungstag der Anmeldung: 27.03.2024
(73) Patentinhaber: Schaeffler Technologies AG & Co. KG, 91074 Herzogenaurach (DE)
(72) Erfinder: HEMMER, Joachim, 96110 Scheßlitz (DE); BREITER, Julian, 93059 Regensburg (DE)
(86) Internationale Anmeldenummer: PCT/DE2022/100366
(87) Internationale Veröffentlichungsnummer: WO 2022/242796

(56) Entgegenhaltungen:
- EP-A1- 2 720 334
- DE-A1- 102012 019 996
- DE-A1- 102014 018 642
- DE-A1- 102017 005 306
- US-A1- 2013 194 101

## Beschreibung

Die Erfindung betrifft eine elektrische Schaltungsanordnung umfassend einen Inverter und eine Messeinrichtung zur Ermittlung eines Kurzschlusses zwischen einem Leiter und einer Schirmung in einer mit dem Inverter verbundenen oder verbindbaren Schaltung, wobei die Schirmung kapazitiv mit einer Masse des Inverters verbunden ist und durch den Inverter eine gepulste Spannung auf dem Leiter erzeugbar ist. Weiterhin betrifft die Erfindung ein Verfahren zur Detektion eines Kurzschlusses zwischen einem Leiter und einer Schirmung in einer mit einer elektrischen Schaltungsanordnung verbundenen Schaltung, wobei die elektrische Schaltungsanordnung einen Inverter und eine Messeinrichtung zur Ermittlung des Kurzschlusses umfasst.

Für elektrische Schaltungsanordnungen in Kraftfahrzeugen gelten strenge Anforderungen an deren elektromagnetische Verträglichkeit (EMV), um Störungen in weiteren elektrischen Schaltungsanordnungen innerhalb und außerhalb des Kraftfahrzeugs zu verhindern. In vielen Fällen umfassen solche elektrische Schaltungsanordnungen Komponenten wie elektrische Maschinen, welche über einen Inverter betrieben werden. Wenn es in der Komponente oder in einem zur Verbindung der Komponente eingesetzten Verbindemittel zu einer Verbindung zwischen einem Leiter mit einer Schirmung kommt, dann tritt ein Kurzschluss auf.

Ein solcher Kurzschluss kann insbesondere dazu führen, dass aufgrund der elektrischen Verbindung zwischen dem Leiter und der Schirmung die Schirmung ihre Schirmwirkung, das heißt das Verhindern einer elektromagnetischen Störaussendung, verliert, sodass die elektromagnetische Verträglichkeit bzw. die geforderten Grenzwerte von der elektrischen Schaltungsanordnung nicht mehr eingehalten werden können. Dies kann beispielsweise bei einem Leiter auftreten, welcher einen Motorphasenstrom führt, da bei Auftreten des Kurzschlusses die gepulste Spannung der Motorphase an dem Schirm anliegt und somit der Schirm seine Schirmwirkung gegenüber dem Leiter maßgeblich verliert.

Um auf die gegebenenfalls reduzierte Abschirmung von Störungen reagieren zu können, ist es wünschenswert, dass das Auftreten eines solchen Kurzschlusses festgestellt bzw. detektiert werden kann. Grundsätzlich ist es bekannt, dass ein Kurzschluss über die Messung eines Kurzschlussstroms festgestellt werden kann. Jedoch können insbesondere bei im Kraftfahrzeug verwendeten elektrischen Schaltungsanordnungen Systemarchitekturen vorliegen, bei denen aufgrund von rein kapazitiven Verbindungen zwischen einzelnen Potentialen bei einem Kurzschluss kein geschlossener Stromkreislauf für einen Gleichstrom bzw. einen niederfrequenten Wechselstrom zwischen dem Leiter und dem Schirm entsteht. In einem solchen Fall wird auch der Kurzschluss nicht zur Ausbildung eines signifikanten Kurzschlussstroms bzw. zu einem Anstieg eines Stroms auf dem über den Kurzschluss mit dem Schirm verbundenen Leiter führen. Dennoch kann auch in einem solchen Fall die Schirmwirkung des Schirmes verloren gehen, sodass es wünschenswert ist, auch das Auftreten eines solchen Kurzschlusses ermitteln zu können.

Aus der DE 10 2014 018642 A1 ist eine elektrische Schaltungsanordnung bekannt, umfassend einen Inverter und eine Messeinrichtung zur Ermittlung eines Kurzschlusses zwischen einer Schirmung und einer Masse in einer mit dem Inverter verbundenen oder verbindbaren Schaltung, wobei die Schirmung kapazitiv mit einer Masse des Inverters verbunden ist, wobei die Messeinrichtung dazu ausgebildet ist, eine Spannung zwischen der Masse des Inverters und der Schirmung auszuwerten.

Der Erfindung liegt daher die Aufgabe zugrunde, eine elektrische Schaltungsanordnung anzugeben, welche eine verbesserte Ermittlung eines Kurzschlusses zwischen einem Leiter und einer Schirmung in einer mit dem Inverter verbundenen oder verbindbaren Schaltung ermöglicht, insbesondere für den Fall, dass der Kurzschluss nicht zum Auftreten eines signifikanten Kurzschlussstroms führt.

Zur Lösung dieser Aufgabe ist bei einer elektrischen Schaltungsanordnung der eingangs genannten Art erfindungsgemäß vorgesehen, dass die Messeinrichtung dazu ausgebildet ist, eine Spannung zwischen der Masse des Inverters und der Schirmung auszuwerten und bei einem Auftreten wenigstens eines Pulses der Spannung ein Kurzschlusssignal zu erzeugen.

Die von dem Inverter auf dem Leiter erzeugte gepulste Spannung kann beispielsweise einen Strom auf den Leiter bewegen, welcher der mit dem Inverter verbundenen oder verbindbaren Schaltung zugeführt wird. Bei dieser Schaltung kann es sich beispielsweise um eine elektrische Maschine oder eine elektrische Maschine umfassende Schaltung handeln. Die elektrische Maschine kann direkt mit dem Inverter verbunden sein und beispielsweise als eine gemeinsame Baueinheit mit dem Inverter in einem Gehäuse angeordnet sein. Es ist auch möglich, dass die Schaltung mit dem Inverter ein Verbindemittel, beispielsweise eine ein- oder mehrphasige Leitung bzw. ein Kabel, umfasst, über das die Schaltung mit dem Inverter verbunden ist oder verbunden werden kann. Der Kurzschluss zwischen dem Leiter und der Schirmung kann in dem Fall in dem Verbindemittel oder zwischen dem Leiter bzw. dem Leiterpotential und der Schirmung bzw. einem Schirmpotential im Inneren einer weiteren Komponente der verbundenen Schaltung bzw. der verbundenen elektrischen Maschine auftreten.

Durch die kapazitive Verbindung zwischen der Masse des Inverters und der Schirmung kann ein Gleichstrom oder ein niederfrequenter Wechselstrom nicht über den Inverter in eine Energiequelle zurückfliesen. Bei Anordnung der elektrischen Schaltungsanordnung derart, dass eine den Inverter speisende Energiequelle ebenfalls kapazitiv mit der Schirmung verbunden bzw. kapazitiv von der Schirmung entkoppelt ist, kann auch über einen solchen Pfad kein Gleichstrom bzw. kein niederfrequenter Wechselstrom fließen. Die gepulste Spannung, welche von dem Inverter auf dem Leiter erzeugbar ist, weist insbesondere eine vergleichsweise niedrige Frequenz, z. B. von einem 1 kHz oder weniger, auf, sodass der auf dem Leiter erzeugte Strom nicht über die kapazitive Anbindungen fließen kann, da diese für den Strom eine hohe Impedanz darstellt.

Daher wird das Auftreten des Kurzschlusses zwischen dem Leiter und dem Schirm dieser erfindungsgemäß durch die Messung der Spannung zwischen der Masse des Inverters und der Schirmung ermittelt. In dem Fall, dass kein Kurzschluss anliegt, ist die Spannung zwischen der Masse des Inverters und der Schirmung nicht gepulst. Bei Vorliegen eines Kurzschlusses zwischen dem Leiter und der Schirmung liegt auch an der Schirmung eine gepulste Spannung an, sodass durch das Auftreten von Pulsen bzw. der gepulsten Spannung auf der Schirmung bzw. an einem mit dem Schirmpotential verbundenen Leiter auf einen Kurzschlusses zurückgeschlossen werden kann. Somit kann das Auftreten des Kurzschlusses detektiert werden, ohne dass ein Kurzschlussstrom bzw. ein erhöhter Strom auf dem Leiter oder Ähnliches für eine Kurzschlussdetektion auftreten muss.

Vorteilhaft kann somit bei Auftreten des Kurzschlusses zwischen dem Leiter und der Schirmung ein das Auftreten des Kurzschlusses beschreibendes Kurzschlusssignal erzeugt werden, aufgrund dessen beispielsweise eine den Kurzschluss berücksichtigende Maßnahme ergriffen werden kann. Beispielsweise kann bei Vorliegen des Kurzschlusssignals bzw. bei Vorliegen eines einen aufgetretenen Kurzschluss beschreibenden Kurzschlusssignals eine Abschaltung des Inverters und/oder einer mit dem Inverter verbundenen Schaltung erfolgen.

Somit kann vermieden werden, dass sich die elektrische Schaltungsanordnung und/oder die mit dieser verbindbare oder verbundene Schalter in einem Betriebszustand befindet, in dem aufgrund eines Kurzschlusses zwischen dem Leiter und der Schirmung eine erhöhte Störungsaussendung erfolgt. Eine Beeinträchtigung weiterer elektrischer Schaltungsanordnungen in der Umgebung der elektrischen Schaltungsanordnung aufgrund eines unentdeckten Kurzschlusses kann somit vorteilhaft vermieden werden. Insbesondere bei einem Einsatz der elektrischen Schaltungsanordnung in einem Kraftfahrzeug können somit Vorgaben für die elektromagnetische Verträglichkeit auch bei Auftreten eines Kurzschlusses eingehalten werden und es können Beeinträchtigungen aufgrund erhöhter Störaussendungen von weiteren Kraftfahrzeugkomponenten und/oder von weiteren elektronischen Schaltungen im Umkreis des Kraftfahrzeugs vermieden werden.

Erfindungsgemäß kann vorgesehen sein, dass die Messeinrichtung dazu ausgebildet ist, das Kurzschlusssignal zu erzeugen, wenn innerhalb einer vorgegebenen Zeit mehrere Pulse der Spannung aufgetreten sind. Die Detektion eines Kurzschlusses und somit die Erzeugung des Kurzschlusssignals erfolgt dabei nur, wenn mehrere Pulse, das heißt das Vorliegen einer Pulsfolge bzw. einer gepulsten und/oder sich periodisch ändernden Spannung, festgestellt werden. Ein einzelner Puls, welcher über die Messeinrichtung festgestellt wird, führt nicht dazu, dass ein Kurzschlusssignal erzeugt wird.

Dies hat den Vorteil, dass einzelne Pulse, welche beispielsweise bei einer sogenannten Electrostatic Discharge (ESD)-Prüfung eingesetzt werden, nicht zu einer Erkennung eines Kurzschlusses führen. Derartige ESD-Pulse können insbesondere bei im Kraftfahrzeug angeordneten elektrischen Schaltungsanordnungen auftreten, da eine ESD-Prüfung ein verbreitetes Prüfverfahren für im Kraftfahrzeug verbaute Komponenten bzw. für komplette Kraftfahrzeuge ist. Die Messeinrichtung ist also in der Lage zu unterscheiden, ob einzelne, sich nicht wiederholende Spannungspulse auftreten, welche nicht durch einen Kurzschluss verursacht werden, und beispielsweise Folge einer ESD-Prüfung sind, oder ob mehrere Pulse der Spannung gemessen werden und folglich aller Wahrscheinlichkeit nach ein Kurzschluss aufgetreten ist. Die vorgegebene Zeit, innerhalb derer die mehreren Pulse auftreten können, kann dabei in Abhängigkeit einer Frequenz der vom Inverter erzeugten gepulsten Spannung gewählt werden und beispielsweise einen Zeitbereich zwischen 1 ms und 1 s betreffen, sodass zwei nachfolgend durchgeführte ESD-Prüfungen ebenfalls nicht zu einer Kurzschlusserkennung führen.

In einer bevorzugten Ausgestaltung der Erfindung kann vorgesehen sein, dass die Messeinrichtung einen Komparator umfasst, wobei an einem ersten Eingang des Komparators die Spannung zwischen der Masse des Inverters und der Schirmung anliegt, und an einem zweiten Eingang des Komparators eine Referenzspannung anliegt, wobei die Messeinrichtung dazu ausgebildet ist, das Kurzschlusssignal aus einem Ausgangssignal des Komparators zu erzeugen.

Die Spannung, welche zwischen der Masse des Inverters und der Schirmung anliegt, kann beispielsweise über wenigstens einem Kondensator abfallen, welcher zwischen einem Masseanschluss des Inverters und einem auf dem Potential der Schirmung liegenden Anschluss geschaltet ist und somit die kapazitive Verbindung bzw. Entkopplung zwischen Schirmung und der Masse des Inverters bewirkt. Der Kondensator kann insbesondere bei einer die elektrische Schaltungsanordnung tragenden Leiterplatte als ein bestücktes Bauteil vorgesehen sein. Zusätzlich zu dem wenigstens einem Kondensator kann die kapazitive Verbindung auch ein oder mehrere resistive Elemente umfassen.

Je nach Höhe der Spannung, welche im Falle eines Kurzschlusses über diesem Kondensator bzw. zwischen der Masse des Inverters und der Schirmung erwartbar anliegen kann, kann die Spannung direkt an den Eingang des Komparators angelegt werden oder es kann ein Spannungsteiler verwendet werden, um die Spannung herabzusetzen, insbesondere wenn die erwartbaren Spannungen oberhalb einer zulässigen Eingangsspannung für den Komparator liegen. Die Verwendung eines Komparators, welcher die an einem ersten Eingang anliegende Spannung mit der Referenzspannung vergleicht, ermöglicht es vorteilhaft, Schwankungen und/oder eine nicht genau vorhersagbare Höhe der am ersten Eingang anliegenden Spannung zu kompensieren und unabhängig von einem tatsächlichen Wert stets das gleiche Ausgangssignal des Komparators, also eine logische 0 oder 1, zu erzeugen. Vorteilhaft können somit Spannungen in einem vorgegebenen Bereich, welche bei dem Kurzschluss auftreten können, ausgewertet werden, wobei unabhängig von der tatsächlichen Höhe stets das gleiche Ausgangssignal des Komparators erzeugt wird. Bei einer Erzeugung des Kurzschlusssignals aus dem Ausgangssignal des Komparators kann somit ein einheitliches Ausgangssignal herangezogen werden, welches auftritt, wenn die am ersten Eingang anliegende Spannung oberhalb der Referenzspannung des Komparators ist. Die Referenzspannung kann zum Beispiel in einem separaten Schaltkreis der Messeinrichtung erzeugt werden. Falls keine galvanische Verbindung zwischen einer Masse des Inverters und einer davon separaten Masse der Messeinrichtung vorhanden ist, kann beispielsweise ein isolierender Komparator, oder ein Komparator mit einem nachgeschaltetem Isolator verwendet werden.

Erfindungsgemäß kann weiterhin vorgesehen sein, dass die Messeinrichtung eine nachtriggerbare monostabile Kippstufe umfasst, wobei die Haltezeit der Kippstufe größer als die Periodendauer der vom Inverter erzeugten gepulsten Spannung ist und das Ausgangssignal des Komparators an dem Eingang der Kippstufe anliegt und die Messeinrichtung dazu ausgebildet ist, das Kurzschlusssignal zu erzeugen, wenn das Ausgangssignal der Kippstufe für eine vorgegebene Zeitdauer einen konstanten Schaltzustand aufweist. Eine nachtriggerbare monostabile Kippstufe, auch als nachtriggerbares Monoflop bezeichnet, ändert durch ein am Eingang der Kippstufe anlegendes Triggersignal für eine bestimmte Zeit ihren Schaltzustand von einem ersten Schaltzustand bzw. Ausgangszustand in einen zweiten Schaltzustand bzw. aktiven Zustand. Anschließend kehrt die Kippstufe nach Ablauf der Haltezeit wieder in den Ausgangszustand zurück, wobei bei einer nachtriggerbaren bzw. retriggerbaren Kippstufe durch ein erneutes, während der Haltezeit eingehendes Triggersignal der Zeitablauf bis zur Rückkehr in den Ausgangzustand erneut gestartet wird und die Kippstufe in aktiven Zustand verbleibt. Ein während dem aktiven, getriggerten Zustand eingehendes, erneutes Triggersignal verlängert somit den aktiven Zeitzustand zeitlich.

Die Haltezeit der monostabilen Kippstufe ist bevorzugt größer als die maximale Periodendauer der vom Inverter erzeugten gepulsten Spannung, wenn der Inverter unterschiedliche Frequenzen erzeugen kann, beispielsweise um unterschiedliche Drehzahlen bei einem mit dem Inverter verbundenen elektrischen Motor einzustellen. Die Haltezeit kann zum Beispiel doppelt so groß wie die Periodendauer bzw. eine maximale Periodendauer der vom Inverter erzeugbaren Spannung sein. Wenn nun ein Kurzschluss vorliegt, so wird am Ausgang der monostabilen Kippstufe ein dauerhaft auf einem logischen Wert liegendes Ausgangssignal erzeugt, da die nachtriggerbare Kippstufe durch die während der Haltezeit eintreffenden Pulse der Spannung zwischen der Masse des Inverters und der Schirmung bzw. die Pulse der Ausgangsspannung des Komparators stets erneut ausgelöst bzw. getriggert wird.

Das Kurzschlusssignal kann dabei erzeugt werden, wenn das Ausgangssignal der monostabilen Kippstufe für eine vorgegebene Zeitdauer, welche insbesondere mehreren Pulse der vom Inverter erzeugten Spannung entspricht, auf dem dem aktiven Schaltzustand entsprechenden logischen Spannungspegel liegt. Auf diese Weise kann ein einfacher Aufbau der Messeinrichtung mit analogen Elementen realisiert werden, welcher erst beim Auftreten mehrerer Pulse ein Kurzschlusssignal erzeugt. Insbesondere im Zusammenhang mit dem Komparator kann somit auch eine Toleranz gegenüber Spannungsschwankungen im Kurzschlussfall erzeugt werden, sodass zuverlässig und schnell eine Diagnose eines aufgetretenen Kurzschlusses erfolgen kann.

Erfindungsgemäß kann vorgesehen sein, dass die elektrische Schaltungsanordnung eine Steuereinrichtung umfasst, wobei das Kurzschlusssignal von der Steuereinrichtung ermittelbar ist oder von der Messeinrichtung an die Steuereinrichtung übermittelbar ist, wobei die Steuereinrichtung dazu ausgebildet ist, bei Vorliegen des Kurzschlusssignals wenigstens eine Maßnahme einzuleiten.

Die Steuereinrichtung kann also ein Teil der Messeinrichtung sein oder sie kann eine zusätzliche Steuereinrichtung der elektrischen Schaltungsanordnung sein. Wenn sie ein Teil der Messeinrichtung ist, dann kann die Steuereinrichtung kann aus einem Ausgangssignal der Messeinrichtung, insbesondere aus dem Ausgangssignal der Kippstufe, das Kurzschlusssignal erzeugen. Dies kann zum Beispiel erfolgen, wenn das Ausgangssignal der Kippstufe für eine vorgegebene Zeitspanne dem aktiven Schaltzustand der Kippstufe entspricht. Die vorgegebene Zeitspanne kann dabei insbesondere einem Vielfachen der Haltedauer der Kippstufe entsprechen und zum Beispiel wenigstens zehn Periodendauern der vom Inverter erzeugten, gepulsten Spannung umfassen. Alternativ ist es möglich, dass das Kurzschlusssignal von einer weiteren Komponente der Messeinrichtung aus dem Ausgangssignal der Kippstufe und/oder des Komparators erzeugt wird, wobei das von der Messeinrichtung erzeugte Kurzschlusssignal, zum Beispiel in Form eines Ein-Bit-Signals bzw. einer einem vorgegebenen Wert entsprechenden Spannung an die Steuereinrichtung übermittelt wird.

Die Steuereinrichtung kann neben der Ermittlung bzw. des Empfangs des Kurzschlusssignals auch noch weitere Funktionen beinhalten, insbesondere kann sie auch eine Steuerung bzw. Regelung des Inverters vornehmen. Dazu kann die Steuereinrichtung mit wenigstens einer Datenkommunikationsschnittstelle verbindbar oder verbunden sein, über die entsprechende Informationen oder Befehle zum Betrieb des Inverters empfangen und/oder gesendet werden können. Bei Vorliegen eines Kurzschlusssignals kann von der Steuereinrichtung eine Maßnahme eingeleitet werden, welche den aufgetretenen Kurzschluss berücksichtigt. Insbesondere kann ein Abschalten des Inverters erfolgen und/oder eine das Vorliegen eines Kurzschlusses beschreibende Kurzschlussinformation kann über eine mit der Steuereinrichtung verbundene Datenschnittstelle übermittelt werden.

In einer bevorzugten Ausgestaltung der Erfindung kann vorgesehen sein, dass die elektrische Schaltungsanordnung einen Massekontakt und/oder ein Gehäuse umfasst, wobei der Massekontakt und/oder das Gehäuse auf dem Potential der Schirmung liegen und die Masse des Inverters kapazitiv mit dem Massekontakt und/oder dem Gehäuse gekoppelt ist. Der Massekontakt kann beispielsweise als eine Bodenplatte aus einem Metall, als ein Layer im Aufbau einer Leiterplatine, insbesondere einer gedruckten Leiterplatte (printed circuit board, PCB), der elektrischen Schaltungsanordnung ausgeführt sein.

Das Massepotential der elektrischen Schaltungsanordnung kann zusätzlich oder alternativ auch an einem Gehäuse, insbesondere einem Metallgehäuse, der elektrischen Schaltung anliegen. Das Potential der Schirmung liegt dabei an dem Massekontakt und/oder an dem Gehäuse an. Dies kann beispielsweise über eine elektrische Verbindung zwischen dem Massekontakt und der Schirmung, insbesondere über einen dafür vorgesehenen Kontaktpin erfolgen. Auch eine Verbindung zu einem Gehäuse der elektrischen Schaltungsanordnung kann z. B. über einen gehäuseseitigen elektrischen Pin erfolgen, welcher mit der Schirmung der Schaltung verbindbar oder verbunden ist.

Erfindungsgemäß kann vorgesehen sein, dass der Inverter mit einem Energiespeicher verbunden oder verbindbar ist, wobei der Energiespeicher mit der Schirmung kapazitiv gekoppelt ist. Bei dem Energiespeicher kann es sich beispielsweise um einen Niedervolt-Energiespeicher, insbesondere eine Niedervoltbatterie, welche eine Spannung von beispielsweise 12 Volt, 24 Volt oder 48 Volt bereitstellt, handeln. Alternativ dazu ist es möglich, dass es sich bei dem Energiespeicher um einen Hochvolt-Energiespeicher, insbesondere eine Hochvoltbatterie, handelt, welcher eine Spannung zwischen 400 Volt und 800 Volt bereitstellt. Die kapazitive Kopplung des Energiespeichers mit der Schirmung kann unmittelbar oder mittelbar erfolgen. Eine mittelbare kapazitive Kopplung kann zum Beispiel vorliegen, wenn der Energiespeicher und die Schirmung jeweils kapazitiv mit einem weiteren Potential, zum Beispiel dem Chassis eines Kraftfahrzeugs, gekoppelt sind.

Bei elektrischen Schaltungsanordnungen, welche in einem Kraftfahrzeug verwendet werden, kann es sich bei dem Niedervolt-Energiespeicher beispielsweise um eine Batterie, welche zur Versorgung eines Niedervolt-Kraftfahrzeugbordnetzes vorgesehen ist, handeln. Bei einem Hochvolt-Energiespeicher kann es sich entsprechend um einen Traktionsenergiespeicher handeln, welcher ein Hochvolt-Bordnetz des Kraftfahrzeuges betreibt und beispielsweise über den Inverter der elektrischen Schaltungsanordnung eine Traktionselektromaschine als mit dem Inverter verbundene Schaltung bestromen kann. Der mit dem Inverter verbundene Energiespeicher ist insbesondere ebenfalls kapazitiv mit der Schirmung oder mit einem mit der Schirmung gekoppelten Chassis gekoppelt, sodass in dem Kurzschlussfall kein Kurzschlussstrom über den Leiter und die Schirmung in den Energiespeicher fließen kann.

In einer bevorzugten Ausgestaltung der Erfindung kann vorgesehen sein, dass die elektrische Schaltungsanordnung eine mit dem Inverter verbundene Schaltung aufweist, wobei die Schaltung wenigstens eine elektrische Maschine umfasst. Der Inverter der elektrischen Schaltungsanordnung kann insbesondere als ein dreiphasiger Inverter, beispielsweise als eine drei Halbbrücken umfassende B6-Brücke bzw. als ein Pulswechselrichter, ausgeführt sein.

Die elektrische Schaltungsanordnung kann ein Wankstabilisator, ein elektrisches Lenkungssystem und/oder ein elektrischer Traktionsantrieb für ein Kraftfahrzeug sein. Auch viele andere Systeme mit dieser Architektur sind denkbar, so dass die elektrische Schaltungsanordnung auch für weitere Einsatzzwecke verwendet werden kann. Bei dem elektrischen Lenksystem kann es sich zum Beispiel um eine Vorderachslenkung oder eine Hinterachslenkung handeln. Bei der elektrischen Maschine der mit dem Inverter verbundenen Schaltung kann es sich folglich zum Beispiel um eine elektrische Traktionsmaschine für ein Kraftfahrzeug handeln. Es ist auch möglich, dass die elektrische Maschine der Schaltung ein Teil eines von einem Traktionsantrieb verschiedenen Kraftfahrzeugaktors ist, welcher über die elektrische Schaltungsanordnung angesteuert bzw. betrieben wird.

Für ein erfindungsgemäßes Verfahren zur Detektion eines Kurzschlusses zwischen einem Leiter und einer Schirmung in einem mit einer elektrischen Schaltungsanordnung verbundenen Schaltung, wobei die elektrische Schaltungsanordnung einen Inverter umfasst und die Schirmung kapazitiv mit einer Masse des Inverters verbunden ist, wobei durch den Inverter eine gepulste Spannung auf dem Leiter erzeugt wird, ist vorgesehen, dass eine Spannung zwischen der Masse des Inverters und der Schirmung ausgewertet wird und bei einem Auftreten wenigstens eines Pulses der Spannung ein Kurzschlusssignal erzeugt wird.

Dabei kann das Kurzschlusssignal erzeugt werden, wenn innerhalb einer vorgegebenen Zeit mehrere Pulse der Spannung aufgetreten sind.

Die elektrische Schaltungsanordnung kann dabei eine Messeinrichtung umfassen, welche die Spannung zwischen der Masse des Inverters und der Schirmung auswertet wird und bei einem Auftreten wenigstens eines Pulses der Spannung ein Kurzschlusssignal erzeugt. Bevorzugt kann die Messeinrichtung dabei einen Komparator umfassen, wobei an einem ersten Eingang des Komparators die Spannung zwischen der Masse des Inverters und der Schirmung anliegt und an einem zweiten Eingang des Komparators eine Referenzspannung anliegt, wobei durch die Messeinrichtung das Kurzschlusssignal aus einem Ausgangssignal des Komparators erzeugt wird.

Bevorzugt kann die Messeinrichtung eine nachtriggerbare monostabile Kippstufe umfassen, wobei die Haltezeit der Kippstufe größer als die Periodendauer der vom Inverter erzeugten gepulsten Spannung ist und das Ausgangssignal des Komparators an dem Eingang der Kippstufe anliegt und das Kurzschlusssignal durch die Messeinrichtung erzeugt wird, wenn das Ausgangssignal der Kippstufe für eine vorgegebene Zeitdauer einen konstanten Schaltzustand aufweist.

Bevorzugt kann die elektrische Schaltungsanordnung eine Steuereinrichtung umfassen, wobei das Kurzschlusssignal von der Steuereinrichtung ermittelt wird oder von der Messeinrichtung an die Steuereinrichtung übermittelt wird, wobei die Steuereinrichtung bei Vorliegen des Kurzschlusses wenigstens eine Maßnahme einleitet.

Sämtliche vorangehende in Bezug zu der erfindungsgemäßen elektrischen Schaltungsanordnung beschriebenen Vorteile und Ausgestaltungen gelten entsprechend für das erfindungsgemäße Verfahren und umgekehrt.

Die Erfindung wird nachfolgend anhand von Ausführungsbeispielen unter Bezugnahme auf die Zeichnungen erläutert. Die Zeichnungen sind schematische Darstellungen und zeigen:
- Figur 1: ein Ausführungsbeispiel einer erfindungsgemäßen elektrischen Schaltungsanordnung, und
- Figur 2: eine Detailansicht der Messeinrichtung der erfindungsgemäßen elektrischen Schaltungsanordnung.

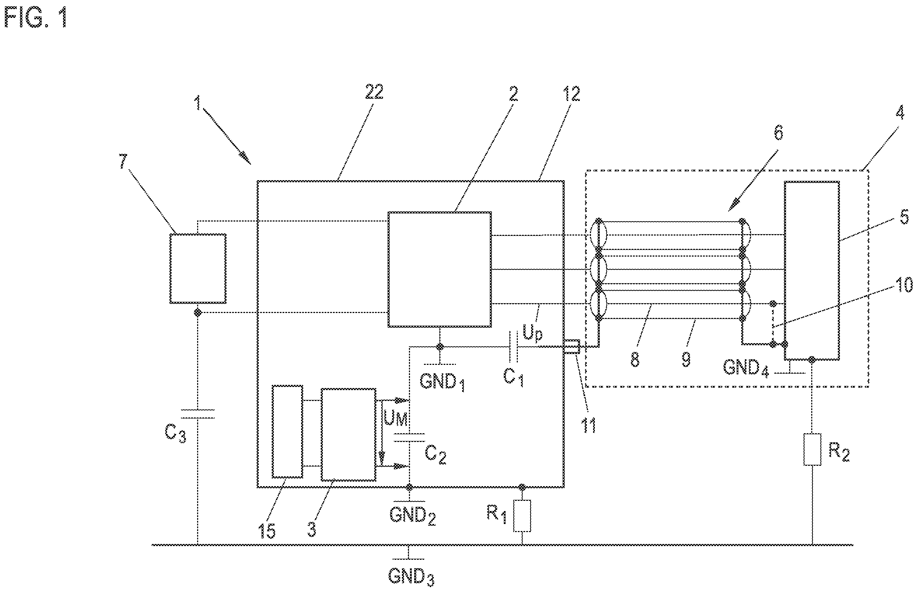

In Figur 1 ist ein Ausführungsbeispiel einer elektrischen Schaltungsanordnung 1 dargestellt. Die elektrische Schaltungsanordnung umfasst einen Inverter 2 sowie eine Messeinrichtung 3 zur Ermittlung eines Kurzschlusses in einer mit dem Inverter 2 verbundenen oder verbindbaren Schaltung 4. Im vorliegenden Beispiel umfasst die mit dem Inverter 2 verbundene Schaltung 4 eine elektrische Maschine 5 sowie ein Verbindemittel 6, welches vorliegend als dreiphasiges, geschirmtes Motorkabel ausgeführt ist. Über das Verbindemittel 6 kann ein im vorliegenden Ausführungsbeispiel dreiphasiger Wechselstrom von dem Inverter 2 an die elektrische Maschine 5 übertragen werden, sodass ein Motorbetrieb der elektrischen Maschine 5 über den Inverter 2 möglich ist. Zum Bereitstellen dieses Wechselstroms ist der Inverter 2 mit einem Energiespeicher 7 verbunden. Der Inverter 2 kann zum Beispiel als B6-Brücke ausgebildet sein.

Die Messeinrichtung 3 ist dazu ausgebildet, einen Kurzschluss zwischen einem Leiter 8 und einer Schirmung 9 der Schaltung 4 zu bestimmen. Dieser Kurzschluss ist als gestrichelte Verbindung 10 zwischen dem Leiter 8 und der Schirmung 9 schematisch dargestellt. Der Kurzschluss kann dabei in dem Verbindemittel 6 oder innerhalb der elektrischen Maschine 5 auftreten.

Der Leiter 8 ist mit einer Wechselstromseite des Inverters 2 verbunden. Die Schirmung 9 ist vorliegend über eine Kapazität C₁ kapazitiv mit einem Massepotential GND₁ des Inverters 2 verbunden. Die Schirmung 9 ist über einen Kontaktpin 11 mit einem Gehäuse 12 der elektrischen Schaltungsanordnung 1 verbunden, wobei das Gehäuse 12 ein Metallgehäuse ist und ein Massepotential GND₁ der elektrischen Schaltungsanordnung 1 darstellt. Zwischen dem Massepotential GND₁ des Inverters 2 und dem Massepotential GND₂ des Gehäuses 12 ist eine Kapazität C₂ angeordnet, sodass die Masse GND₁ des Inverters auch über die Kapazität C₂ kapazitiv mit der mit dem Gehäuse 12 verbundenen Schirmung 9 gekoppelt ist.

Zusätzlich zu den Kapazitäten C₁ und C₂ kann die Verbindung zwischen GND₁ und GND₂ auch ein oder mehrere resistive Elemente umfassen. Die Kapazitäten C₁ und C₂ sowie die gegebenenfalls vorhandenen resistiven Elemente können zum Beispiel auf einer Leiterplatte, auf der die elektrische Schaltungsanordnung 1 ganz oder teilweise ausgebildet ist, als bestückte Kondensatoren bzw. Widerstände ausgebildet sein.

Die elektrische Schaltungsanordnung 1 ist in einer Einbausituation in einem Kraftfahrzeug dargestellt, wobei zusätzlich die Verbindungen der Komponenten zu einem Massepotential GND₃ des Kraftfahrzeugs, beispielsweise eine Masse eines Chassis des Kraftfahrzeugs, eingezeichnet sind. Das Gehäuse 12 ist über einen Widerstand R₁ resistiv mit der Masse GND₃ verbunden. Auch ein Massepotential GND₄ der elektrischen Maschine 5 der Schaltung 4 ist über einen Widerstand R₂ resistiv mit der Masse GND₃ gekoppelt. Der Energiespeicher 7 ist ebenfalls kapazitiv über eine Kapazität C₃ mit der Masse GND₃ gekoppelt. Bei Auftreten des Kurzschlusses 10 zwischen dem Leiter 8 und der Schirmung 9 läuft jeder mögliche Kurzschlussstrompfad über wenigstens eine der durch die Kapazitäten C1, C2 und C3 gebildeten, kapazitiven Verbindungen. Auf diese Weise kann ein Gleichstrom bzw. ein niederfrequenter Wechselstrom nicht als Kurzschlussstrom fließen, da die kapazitiven Verbindungen für einen solchen Strom jeweils eine unendliche bzw. zumindest eine sehr hohe Impedanz darstellen.

Der Inverter 2 erzeugt eine gepulste, vorliegend dreiphasige Spannung, zum Beispiel bei einer Schaltfrequenz zwischen 1 kHz und 500 kHz, insbesondere zwischen 10 kHz und 20 kHz, auf den Leitern 8 der Schaltung 4. Diese Spannung bewirkt einen Strom auf den Leitern 8 der Schaltung 4, dessen Frequenz zum Beispiel zwischen 1 Hz und 10 kHz, insbesondere zwischen 1 Hz und 1 kHz, beträgt. Bei Auftreten eines Kurzschlusses zwischen dem Leiter 8 und der Schirmung 9 liegt die mit der Schaltfrequenz des Inverters gepulste Spannung U_{P} einer der Phasen auch an der Schirmung 9 an, wobei die Frequenz der Spannung U_{P} deutlich hochfrequenter als die auch als Motorstromgrundfrequenz bezeichnete Frequenz des in die elektrische Maschine 5 gespeisten Stromes ist.

Durch die an der Schirmung 9 anliegende Spannung U_{P} verliert diese ihre Schirmwirkung. Dies kann eine verschlechterte elektromagnetische Verträglichkeit (EMV) der Schaltung 4 zur Folge haben, weshalb die Messeinrichtung 3 zur Detektion eines solchen Kurzschlusses ausgebildet ist. Da die Messung eines Kurzschlusses nicht über einen Kurzschlussstrom bzw. über eine Messung der auf den Leitern 8 fließenden Phasenströme zum Bestromen der elektrischen Maschine 5 möglich ist, wird durch die Messeinrichtung 3 eine Spannung U_{M} zwischen der Masse GND₁ des Inverters 2 und der Schirmung 9 ausgewertet. Die Spannung U_{M} entspricht der Schaltfrequenz des Inverters 2 und ist deutlich hochfrequenter als die Motorstromfrequenz. Die Messeinrichtung 3 ist außerdem dazu eingerichtet, bei einem Auftreten wenigstens eines Pulses dieser Spannung ein Kurzschlusssignal zu erzeugen

Das Gehäuse 12 der elektrischen Schaltungsanordnung 11 kann als ein Metallgehäuse ausgeführt sein, welches mit dem Massepotential GND₂ verbunden ist. Alternativ ist auch eine Ausführung des Massekontakts des Massepotentials GND₂ als eine leitfähige Metallplatte und/oder als ein Layer einer Leiterplatte, beispielsweise einer gedruckten Leiterplatte, der elektrischen Schaltungsanordnung 1 möglich.

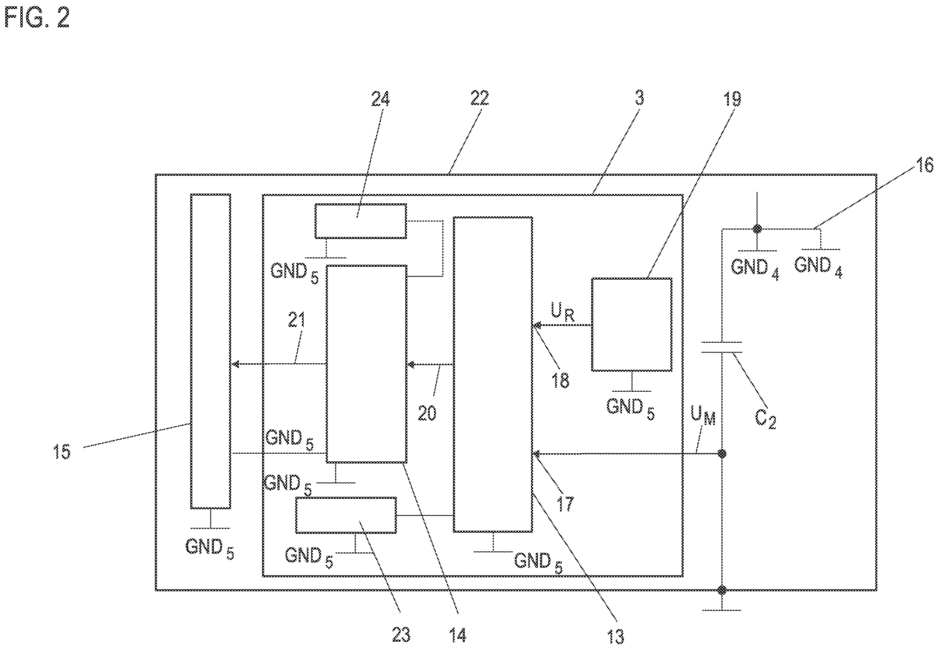

In Figur 2 ist schematisch der Aufbau der Messeinrichtung 3 dargestellt. Die Messeinrichtung 3 umfasst einen Komparator 13 sowie eine Kippstufe 14. Weiterhin umfasst die Messeinrichtung 3 eine Steuereinrichtung 15, welche beispielsweise als ein Mikrokontroller ausgeführt ist. Alternativ ist die Messeinrichtung 3 mit einer Steuereinrichtung 15 der elektrischen Schaltungsanordnung 1 verbunden, wie nachfolgend genauer erläutert wird. Das Massepotential der Steuereinrichtung 15 ist in Figur 2 als GND₅ bezeichnet. Das Massepotential GND₅ der Steuereinrichtung 15 kann mit dem Massepotential GND₁ des Inverters 2 galvanisch verbunden sein. Dazu kann beispielsweise eine galvanische Verbindung 16 in Form einer Leiterbahn auf einer Platine der elektrischen Schaltungseinrichtung 1 vorgesehen sein. Alternativ kann auch eine andere Art der galvanischen Verbindung 16 erfolgen, zum Beispiel eine verbindende Metallisierung zwischen den den Massepotentialen GND₁ und GND₅ zugewiesenen Äquipotentialflächen einer oder mehrerer Leiterplatten der elektrischen Schaltungsanordnung 1. Falls keine galvanische Verbindung zwischen dem Massepotential GND₁ des Inverters 2 und dem Massepotential GND₅ vorhanden ist, kann der Komparator 13 auch als ein isolierender Komparator, oder als ein Komparator mit einem nachgeschaltetem Isolator ausgeführt werden.

Die Spannung U_{M} zwischen der Masse GND₁ des Inverters 2 bzw. der mit dieser verbundenen Masse GND₅ der Steuereinrichtung 15 und der Schirmung bzw. dem Massepotential GND₂ der elektrischen Schaltungsanordnung 1 liegt an einem ersten Eingang 17 des Komparators 13 an. An einem zweiten Eingang 18 des Komparators ist eine Referenzspannungsquelle 19 angeschlossen, sodass die am ersten Anschluss 17 anliegende Spannung mit der am zweiten Anschluss 18 anliegenden Referenzspannung U_{R} verglichen wird. Beispielsweise kann es sich bei dem ersten Anschluss 17 um einen negativen Anschluss des Komparators und bei dem zweiten Anschluss 18 um einen positiven Anschluss des Komparators handeln. Auch eine umgekehrte Zuordnung ist möglich. Je nach der Höhe der Spannungen, welche zwischen der Schirmung 9 und der Masse GND₁ des Inverters 2 auftreten können, kann die Messeinrichtung 3 einen Spannungsteiler umfassen, sodass die Spannungen U_{M} auf ein zum Eingang 18 des Komparators 13 passendes Spannungsniveau abgesenkt werden können.

Der Ausgang 20 des Komparators 13 ist mit der Kippstufe 14 verbunden. Die Kippstufe 14 ist als eine nachtriggerbare monostabile Kippstufe, auch als nachtriggerbares Monoflop bezeichnet, ausgeführt und kann beispielsweise in Form eines integrierten Schaltkreises (Integrated circuit, IC) vorliegen. Die Haltezeit der Kippstufe 14 ist dabei größer als die Periodendauer der vom Inverter 2 erfolgten gepulsten Spannung Uₚ, welche an dem Leiter 8 bzw. im Fall eines Kurzschlusses auch an der Schirmung 9 anliegt. Die Haltezeit kann beispielsweise wenigstens doppelt so groß wie die Periodendauer bzw. wie eine maximal vom Inverter 2 bei Betrieb der Schaltung 4 bzw. der elektrischen Maschine 5 erzeugbare Periodendauer sein.

Durch die Verwendung des Komparators 13 wird es ermöglicht, dass auch bei unterschiedlich hohen Spannungen zwischen der Masse GND₁ des Inverters 2 und der Schirmung 9 ein gleichartiges, einem logischen Pegel entsprechendes Ausgangssignal am Ausgang 20 des Komparators 13 erzeugt wird, wenn die gemessene Spannung U_{M} die Referenzspannung U_{R} überschreitet. Auf diese Weise kann die Messeinrichtung 3 robust und für unterschiedliche hohe, auftretende Spannungen U_{M} ausgeführt werden. Dies verbessert die Zuverlässigkeit der Messeinrichtung 3 bzw. der elektrischen Schaltungsanordnung 1 bei der Detektion des Kurzschlusses.

Durch die Verwendung der monostabilen Kippstufe 14 wird es ermöglicht, die Messeinrichtung 3 derart auszuführen, dass sie das Kurzschlusssignal erzeugt, wenn innerhalb einer vorgegebenen Zeit mehrere Pulse der gemessenen Spannung U_{M} aufgetreten sind. Wenn die Kippstufe 14 als nachtriggerbare monostabile Kippstufe ausgeführt ist und die Haltezeit eines aktivierten Zustands der Kippstufe 14 größer als die Periodendauer der vom Inverter 2 erzeugten gepulsten Spannung Uₚ ist, wird bei Auftreten eines Kurzschlusses die Haltezeit der Kippstufe 14 fortlaufend nachgetriggert, sodass sich an einem Ausgang 21 der Kippstufe 14 ein konstanter Signalpegel gibt.

Wenn dieser für eine vorgegebene Zeit, welche insbesondere größer als ein oder mehrere Periodendauern der vom Inverter 2 erzeugten gepulsten Spannung anliegt, kann auf einen Kurzschluss geschlossen werden. Der Ausgang 21 der Kippstufe 14 kann mit der Steuereinrichtung 15 verbunden sein, wobei die Steuereinrichtung 15 die entsprechende Auswertung des Ausgangs 21 vornimmt. Das heißt, durch die Steuereinrichtung 15 wird überwacht, ob für die vorgegebene Zeit ein aktiver Schaltzustand der Kippstufe 14 vorliegt. Alternativ kann auch eine andere Art der Auswertung erfolgen, zum Beispiel durch eine weitere, insbesondere analoge Komponente der Messeinrichtung 3. In diesem Fall kann die Steuereinrichtung keine Komponente der Messeinrichtung darstellen, wobei das von der Messeinrichtung 3 erzeugte Kurzschlusssignal an die Steuereinrichtung 15 übermittelt wird.

Beide Fälle haben den Vorteil, dass das Kurzschlusssignal analog vorliegt bzw. anhand der Zeitdauer eines analogen Signals am Ausgang 21 der Kippstufe 14 ermittelt wird, sodass das Kurzschlusssignal schnell und ohne Digitalisierungsverzögerung für das Einleiten von Maßnahmen aufgrund des Kurzschlusses verwendet werden kann. Beispielsweise ist es möglich, dass das Kurzschlusssignal an die elektrische Maschine 5 oder eine andere Komponente der Schaltung 4 übermittelt wird, sodass deren Betrieb eingestellt wird. Auch eine andere Art der Verwendung in der Schaltung 4 ist möglich, insbesondere wenn die Schaltung 4 einen anderen als den gezeigten Aufbau aufweist. Weiterhin ist es möglich, dass die Steuereinrichtung 15 an eine Kommunikationsverbindung angeschlossen ist, sodass die Kurzschlussinformation und/oder Informationen von aufgrund des Kurzschlusses durchzuführender Maßnahmen auch an andere Komponenten eines Kraftfahrzeugs übermittelt werden können.

Die elektrische Schaltungsanordnung 1 kann beispielsweise als ein Wankstabilisator, ein elektrisches Lenkungssystem und/oder als ein elektrischer Traktionsantrieb für ein Kraftfahrzeug ausgeführt sein. Es ist möglich, dass die Schaltung 4 einen Teil der Schaltungsanordnung 1 darstellt, insbesondere dass die elektrische Maschine 5 unmittelbar mit dem Inverter 2 verbunden ist und kein Verbindemittel 6 eingesetzt wird. Auch in einem solchen Fall kann ein Kurzschluss zwischen einem Leiter 8 bzw. einem Leitungspotential und einer Schirmung 9 bzw. einem Schirmungspotential im Inneren des Motors 5 festgestellt werden. Wie in Figur 2 gezeigt ist, können die Messeinrichtung 3 und die Steuereinrichtung 15 als ein mit dem Inverter 2 verbundene Steuergerät 22 ausgeführt sein. Das Steuergerät 22 kann weiterhin eine Einrichtung 23 zur Erzeugung einer Versorgungsspannung für den Komparator 13 sowie eine Einrichtung 24 zur Erzeugung einer Versorgungsspannung für die Kippstufe 24 aufweisen. Es ist möglich, dass der Inverter 2 ebenfalls als Teil des Steuergeräts 22 ausgeführt ist, so wie es in Figur 1 dargestellt ist.

Der Energiespeicher 7 kann als ein Niedervolt-Energiespeicher, beispielsweise als eine Niedervolt-Batterie, ausgeführt sein und ein Spannungsniveau von 12 Volt, 24 Volt oder 48 Volt aufweisen. Dies ist insbesondere möglich, wenn die elektrische Schaltungsanordnung 1 als ein Wankstabilisator oder ein elektrisches Lenkungssystem ausgeführt ist. Bei einer als elektrischem Traktionsantrieb für ein Kraftfahrzeug ausgeführten Schaltungsanordnung 1 kann der Energiespeicher 7 als ein Hochvolt-Energiespeicher, insbesondere eine Hochvolt-Batterie, ausgeführt sein, und eine Spannung zwischen 700 Volt und 800 Volt bereitstellen. Je nach Ausführung der elektrischen Schaltungsanordnung 1 kann auch die Schaltung 4, insbesondere die Baugröße und/oder die umzusetzende Leistung der elektrischen Maschine 5, unterschiedlich gewählt werden. Auch ein Einsatz der elektrischen Schaltungsanordnung 1 für weitere Einsatzzwecke neben den vorangehend genannten ist möglich.

In einem Ausführungsbeispiel des erfindungsgemäßen Verfahrens wird durch die Messeinrichtung 3 die Spannung U_{M} zwischen der Masse GND₁ des Inverters 2 und der Schirmung 9 ausgewertet und bei einem Auftreten mehrerer Pulse der Spannung U_{M}, also beim Auftreten einer gepulsten Spannung U_{M} an der Schirmung 9 in Bezug auf die Masse GND₁ des Inverters 2, wird ein Kurzschlusssignal erzeugt. Dazu wird die Spannung U_{M} am ersten Eingang 17 des Komparators 13 mit der Referenzspannung U_{R} am zweiten Eingang 18 des Komparators 13 verglichen. Bei einem Überschreiten der Referenzspannung U_{R} wird ein beispielsweise ein auf einer logischen eins liegendes Ausgangssignal am Ausgang 20 erzeugt. Dieses triggert die Kippstufe 14, sodass diese an ihrem Ausgang 21 beispielsweise ebenfalls eine logische eins erzeugt.

Da die Haltezeit der Kippstufe 14 größer als die Periodendauer der gepulsten Spannung Uₚ des Inverters 2 und somit auch der gepulsten Spannung U_{M} zwischen der Masse GND₁ des Inverters 2 und der Schirmung 9 im Fall eines Kurzschlusses ist, wird ein fortlaufendes Nachtriggern der Kippstufe 14 erreicht. Am Ausgang 20 der Kippstufe liegt somit zum Beispiel dauerhaft eine logische eins an, wobei das Kurzschlusssignal durch die Steuereinrichtung 15 erzeugt wird, wenn diese logische eins für eine Zeitdauer, welche größer als die Haltezeit des der Kippstufe 14 ist, anliegt. Dabei kann die Haltedauer der Kippstufe 14 zum Beispiel dem doppelten der Periodendauer von Uₚ entsprechen und die Zeitdauer, für welche die Steuereinrichtung 15 das Signal am Ausgang 21 der Kippstufe 14 auswertet, kann ein Vielfaches, zum Beispiel das Zehnfache, der Periodendauer der Spannung Up betragen und somit ebenfalls die Haltedauer der Kippstufe übersteigen.

Bei der Wahl einer geringeren Haltezeit des Kippstufe sowie einer geringeren Zeitdauer, für welche die Steuereinrichtung 15 das Signal am Ausgang 21 der Kippstufe 14 auswertet, ist es auch möglich, dass ein einzelner Puls der Spannung U_{M} zur Erzeugung eines einen aufgetretenen Kurzschluss beschreibenden Kurzschlusssignals führt. Dies kann zum Beispiel erfolgen, wenn keine Robustheit der Kurzschlusserkennung gegenüber einer ESD-Prüfung erforderlich ist.

Von der Steuereinrichtung 15 kann anschließend eine Maßnahme ergriffen werden, um dem aufgetretenen Kurzschluss zu begegnen. Beispielsweise kann die Steuereinrichtung 15 auch zur Steuerung bzw. Regelung des Inverters 2 ausgebildet sein und ein Abschalten des Inverters 2 vornehmen. Zusätzlich oder alternativ dazu kann die Steuereinrichtung 15 eine entsprechende Kurzschlussinformation über eine Datenschnittstelle (hier nicht dargestellt) übertragen, sodass beispielsweise bei Anordnung der elektrischen Schaltung 1 in einem Kraftfahrzeug auch von anderen Komponenten des Kraftfahrzeugs eine entsprechende Maßnahme ergriffen werden kann.

Die Verwendung der Kippstufe 14 und das Detektieren mehrerer Pulse in der Spannung U_{M} hat den Vorteil, dass ein einzelner Puls, welcher beispielsweise im Rahmen einer ESD-Prüfung auftreten kann, nicht als ein Kurzschluss zwischen dem Leiter 8 und der Schirmung 9 detektiert wird. Erst mehrere Pulse innerhalb einer vorgegebenen Zeit, welche beispielsweise zwischen 1 ms und 1 s kann, werden von der Messeinrichtung 3 als ein Kurzschluss interpretiert. Auf diese Weise wird gewährleistet, dass bei einer ESD-Prüfung eines Kraftfahrzeugs, welches die elektrische Schaltungsanordnung 1 umfasst, kein Kurzschluss detektiert wird.

### Bezugszeichenliste

- 1: Schaltungsanordnung
- 2: Inverter
- 3: Messeinrichtung
- 4: Schaltung
- 5: Motor
- 6: Verbindemittel
- 7: Energiespeicher
- 8: Leiter
- 9: Schirmung
- 10: Verbindung
- 11: Kontaktpin
- 12: Gehäuse
- 13: Komparator
- 14: Kippstufe
- 15: Steuereinrichtung
- 16: Verbindung
- 17: erster Eingang
- 18: zweiter Eingang
- 19: Referenzspannungsquelle
- 20: Ausgang
- 21: Ausgang
- 22: Steuergerät
- 23: Einrichtung
- 24: Einrichtung

## Patentansprüche

1. Elektrische Schaltungsanordnung umfassend einen Inverter (2) und eine Messeinrichtung (3) zur Ermittlung eines Kurzschlusses zwischen einem Leiter (8) und einer Schirmung (9) in einer mit dem Inverter (2) verbundenen oder verbindbaren Schaltung (4), wobei die Schirmung (9) kapazitiv mit einer Masse (GND₁) des Inverters (2) verbunden ist und durch den Inverter (2) eine gepulste Spannung (U_{P}) auf dem Leiter (8) erzeugbar ist, wobei die Messeinrichtung (3) dazu ausgebildet ist, eine Spannung (U_{M}) zwischen der Masse (GND₁) des Inverters (2) und der Schirmung (9) auszuwerten und bei einem Auftreten wenigstens eines Pulses der Spannung (U_{M}) ein Kurzschlusssignal zu erzeugen.

2. Elektrische Schaltungsanordnung nach Anspruch 1, **dadurch gekennzeichnet, dass** die Messeinrichtung (3) dazu ausgebildet ist, das Kurzschlusssignal zu erzeugen, wenn innerhalb einer vorgegebenen Zeit mehrere Pulse der Spannung (U_{M}) aufgetreten sind.

3. Elektrische Schaltungsanordnung nach Anspruch 1 oder 2, **dadurch gekennzeichnet, dass** die Messeinrichtung einen Komparator (13) umfasst, wobei an einem ersten Eingang (17) des Komparators (13) die Spannung (U_{M}) zwischen der Masse (GND₁) des Inverters (2) und der Schirmung (9) anliegt und an einem zweiten Eingang (18) des Komparators (13) eine Referenzspannung (U_{R}) anliegt, wobei die Messeinrichtung (3) dazu ausgebildet ist, das Kurzschlusssignal aus einem Ausgangssignal des Komparators (13) zu erzeugen.

4. Elektrische Schaltungsanordnung nach Anspruch 3, **dadurch gekennzeichnet, dass** die Messeinrichtung (3) eine nachtriggerbare monostabile Kippstufe (14) umfasst, wobei die Haltezeit der Kippstufe (14) größer als die Periodendauer der vom Inverter erzeugten gepulsten Spannung (U_{P}) ist und das Ausgangssignal des Komparators (13) an dem Eingang der Kippstufe (14) anliegt und die Messeinrichtung (3) dazu ausgebildet ist, das Kurzschlusssignal zu erzeugen, wenn das Ausgangssignal der Kippstufe (14) für eine vorgegebene Zeitdauer einen konstanten Schaltzustand aufweist.

5. Elektrische Schaltungsanordnung nach einem der vorangehenden Ansprüche, **dadurch gekennzeichnet, dass** die elektrische Schaltungsanordnung (1) eine Steuereinrichtung (15) umfasst, wobei das Kurzschlusssignal von der Steuereinrichtung (15) ermittelbar ist oder von der Messeinrichtung (3) an die Steuereinrichtung (15) übermittelbar ist, wobei die Steuereinrichtung (15) dazu ausgebildet ist, bei Vorliegen des Kurzschlusssignals wenigstens eine Maßnahme einzuleiten.

6. Elektrische Schaltungsanordnung nach einem der vorangehenden Ansprüche, **dadurch gekennzeichnet, dass** sie einen Massekontakt und/oder ein Gehäuse (12) umfasst, wobei der Massekontakt und/oder das Gehäuse (12) auf dem Potential der Schirmung (9) liegen und die Masse (GND₁) des Inverters (2) kapazitiv mit dem Massekontakt und/oder dem Gehäuse (12) gekoppelt ist.

7. Elektrische Schaltungsanordnung nach einem der vorangehenden Ansprüche, **dadurch gekennzeichnet, dass** der Inverter (2) mit einem Energiespeicher (7) verbunden oder verbindbar ist, wobei der Energiespeicher (7) mit der Schirmung (9) kapazitiv gekoppelt ist.

8. Elektrische Schaltungsanordnung nach einem der vorangehenden Ansprüche, **dadurch gekennzeichnet, dass** sie eine mit dem Inverter (2) verbundene Schaltung (4) aufweist, wobei die Schaltung wenigstens eine elektrische Maschine (5) umfasst.

9. Elektrische Schaltungsanordnung nach Anspruch 8, **dadurch gekennzeichnet, dass** die elektrische Schaltungsanordnung (1) ein Wankstabilisator, ein elektrisches Lenkungssystem und/oder ein elektrischer Traktionsantrieb für ein Kraftfahrzeug ist.

10. Verfahren zur Detektion eines Kurzschlusses zwischen einem Leiter (8) und einer Schirmung (9) in einer mit einer elektrischen Schaltungsanordnung (1) verbundenen Schaltung (4), wobei die elektrische Schaltungsanordnung (1) einen Inverter (2) umfasst und die Schirmung (9) kapazitiv mit einer Masse (GND₁) des Inverters (2) verbunden ist, wobei durch den Inverter (2) eine gepulste Spannung (U_{P}) auf dem Leiter (8) erzeugt wird, wobei eine Spannung (U_{M}) zwischen der Masse (GND₁) des Inverters (2) und der Schirmung (9) ausgewertet wird und bei einem Auftreten wenigstens eines Pulses der Spannung (U_{M}) ein Kurzschlusssignal erzeugt wird.

## Claims

1. An electrical circuit arrangement comprising an inverter (2) and a measuring device (3) for identifying a short circuit between a conductor (8) and a shielding (9) in a circuit (4) that is connected or can be connected to the inverter (2), wherein the shielding (9) is connected capacitively to a ground (GND₁) of the inverter (2), and a pulsed voltage (U_{P}) can be generated on the conductor (8) by the inverter (2), wherein the measuring device (3) is designed to evaluate a voltage (U_{M}) between the ground (GND₁) of the inverter (2) and the shielding (9) and to generate a short circuit signal when at least one pulse of the voltage (U_{M}) occurs.

2. The electrical circuit arrangement according to claim 1, **characterized in that** the measuring device (3) is designed to generate the short circuit signal when a plurality of pulses of the voltage (U_{M}) have occurred within a specified period of time.

3. The electrical circuit arrangement according to claim 1 or 2, **characterized in that** the measuring device comprises a comparator (13), wherein the voltage (U_{M}) is applied between the ground (GND₁) of the inverter (2) and the shielding (9) at a first input (17) of the comparator (13) and a reference voltage (U_{R}) is applied at a second input (18) of the comparator (13), wherein the measuring device (3) is designed to generate the short circuit signal from an output signal of the comparator (13).

4. The electrical circuit arrangement according to claim 3, **characterized in that** the measuring device (3) comprises a retriggerable mono-stable trigger circuit (14), wherein the holding time of the trigger circuit (14) is greater than the period of the pulsed voltage (U_{P}) generated by the inverter and the output signal of the comparator (13) is applied to the input of the trigger circuit (14) and the measuring device (3) is designed to generate the short circuit signal when the output signal of the trigger circuit (14) has a constant switching state for a predetermined period of time.

5. The electrical circuit arrangement according to any one of the preceding claims, **characterized in that** the electrical circuit arrangement (1) comprises a control device (15), wherein the short circuit signal can be identified by the control device (15) or can be transmitted from the measuring device (3) to the control device (15), wherein the control device (15) is designed to initiate at least one action when the short circuit signal is present.

6. The electrical circuit arrangement according to any one of the preceding claims, **characterized in that** it comprises a ground contact and/or a housing (12), wherein the ground contact and/or the housing (12) are at the potential of the shielding (9) and the ground (GND₁) of the inverter (2) is coupled capacitively to the ground contact and/or the housing (12).

7. The electrical circuit arrangement according to any one of the preceding claims, **characterized in that** the inverter (2) is connected or can be connected to an energy store (7), wherein the energy store (7) is coupled capacitively to the shielding (9).

8. The electrical circuit arrangement according to any one of the preceding claims, **characterized in that** it has a circuit (4) connected to the inverter (2), wherein the circuit comprises at least one electrical machine (5).

9. The electrical circuit arrangement according to claim 8, **characterized in that** the electrical circuit arrangement (1) is a roll stabilizer, an electric steering system and/or an electric traction drive for a motor vehicle.

10. A method for detecting a short circuit between a conductor (8) and a shielding (9) in a circuit (4) connected to an electrical circuit arrangement (1), wherein the electrical circuit arrangement (1) comprises an inverter (2) and the shielding (9) is connected capacitively to a ground (GND₁) of the inverter (2), wherein a pulsed voltage (U_{P}) is generated on the conductor (8) by the inverter (2), wherein a voltage (U_{M}) is evaluated between the ground (GND₁) of the inverter (2) and the shielding (9) and a short circuit signal is generated when at least one pulse of the voltage (U_{M}) occurs.

## Revendications

1. Agencement de circuit électrique comprenant un onduleur (2) et un dispositif de mesure (3) pour déterminer un court-circuit entre un conducteur (8) et un blindage (9) dans un circuit (4) connecté ou pouvant être connecté à l'onduleur (2), le blindage (9) étant connecté de manière capacitive avec une masse (GND₁) de l'onduleur (2) et une tension pulsée (U_{P}) pouvant être générée par l'onduleur (2) sur le conducteur (8), le dispositif de mesure (3) étant conçu pour évaluer une tension (U_{M}) entre la masse (GND₁) de l'onduleur (2) et le blindage (9) et pour générer un signal de court-circuit lorsque se produit au moins une impulsion de la tension (U_{M}).

2. Agencement de circuit électrique selon la revendication 1, **caractérisé en ce que** le dispositif de mesure (3) est conçu pour générer le signal de court-circuit lorsque plusieurs impulsions de la tension (U_{M}) se sont produites au cours d'une période de temps prédéterminée.

3. Agencement de circuit électrique selon la revendication 1 ou 2, **caractérisé en ce que** le dispositif de mesure comprend un comparateur (13), la tension (U_{M}) entre la masse (GND₁) de l'onduleur (2) et le blindage (9) étant appliquée à une première entrée (17) du comparateur (13) et une tension de référence (U_{R}) étant appliquée à une seconde entrée (18) du comparateur (13), le dispositif de mesure (3) étant conçu pour générer le signal de court-circuit à partir d'un signal de sortie du comparateur (13).

4. Agencement de circuit électrique selon la revendication 3, **caractérisé en ce que** le dispositif de mesure (3) comprend une bascule monostable à post-déclenchement (14), le temps de maintien de la bascule (14) étant supérieur à la période de la tension pulsée (U_{P}) générée par l'onduleur, le signal de sortie du comparateur (13) étant appliqué à l'entrée de la bascule (14) et le dispositif de mesure (3) étant conçu pour générer le signal de court-circuit lorsque le signal de sortie de la bascule (14) présente un état de commutation constant pendant une période de temps prédéterminée.

5. Agencement de circuit électrique selon l'une des revendications précédentes, **caractérisé en ce que** l'agencement de circuit électrique (1) comprend un dispositif de commande (15), le signal de court-circuit pouvant être déterminé par le dispositif de commande (15) ou transmis au dispositif de commande (15) par le dispositif de mesure (3), le dispositif de commande (15) étant conçu pour déclencher au moins une mesure lorsque le signal de court-circuit est présent.

6. Agencement de circuit électrique selon l'une des revendications précédentes, **caractérisé en ce qu'**il comprend un contact de masse et/ou un boîtier (12), le contact de masse et/ou le boîtier (12) étant au potentiel du blindage (9) et la masse (GND₁) de l'onduleur (2) étant couplée de manière capacitive au contact de masse et/ou au boîtier (12).

7. Agencement de circuit électrique selon l'une des revendications précédentes, **caractérisé en ce que** l'onduleur (2) est connecté ou peut être connecté à un accumulateur d'énergie (7), l'accumulateur d'énergie (7) étant couplé de manière capacitive au blindage (9).

8. Agencement de circuit électrique selon l'une des revendications précédentes, **caractérisé en ce qu'**il présente un circuit (4) connecté à l'onduleur (2), le circuit comprenant au moins une machine électrique (5).

9. Agencement de circuit électrique selon la revendication 8, **caractérisé en ce que** l'agencement de circuit électrique (1) est un stabilisateur de roulis, un système de direction électrique et/ou un entraînement de traction électrique pour un véhicule automobile.

10. Procédé de détection d'un court-circuit entre un conducteur (8) et un blindage (9) dans un circuit (4) connecté à un agencement de circuit électrique (1), l'agencement de circuit électrique (1) comprenant un onduleur (2) et le blindage (9) étant connecté de manière capacitive avec une masse (GND₁) de l'onduleur (2), une tension pulsée (U_{P}) étant générée par l'onduleur (2) sur le conducteur (8), une tension (U_{M}) entre la masse (GND₁) de l'onduleur (2) et le blindage (9) étant évaluée et un signal de court-circuit étant généré lorsque se produit au moins une impulsion de la tension (U_{M}).
